# EUROPÄISCHE PATENTANMELDUNG

(11) **EP 3 505 960 A1**
(43) Veröffentlichungstag der Anmeldung: **03.07.2019**
(21) Anmeldenummer: 18203502.2
(22) Anmeldetag: 30.10.2018
(51) Int. Cl.: G01S 17/02, G01S 7/481, H05K 5/00, H05K 1/14

(54) **TIME-OF-FLIGHT-SENSORMODUL UND VERFAHREN ZUM ZUSAMMENFÜGEN EINES TIME-OF-FLIGHT-SENSORMODULS**

(30) Priorität: 29.12.2017 DE 102017131424
(71) Anmelder: HUF Hülsbeck & Fürst GmbH & Co. KG, 42551 Velbert (DE)
(72) Erfinder: STICHERLING, Nadine, 45257 Essen (DE); KOTT, Christopher, 42109 Wuppertal (DE); WENZEL, Oliver, 40227 Düsseldorf (DE); THAU, Wolfgang, 58285 Gevelsberg (DE)
(74) Vertreter: Zenz Patentanwälte Partnerschaft mbB

(57) **Zusammenfassung**

Die Erfindung betrifft ein Time-of-Flight-Sensormodul, abgekürzt: TOF-Sensormodul. Das TOF-Sensormodul weist eine Sensoranordnung mit den folgenden Bestandteilen auf:
- eine Platinenanordnung (2),
- einen Moduleinsatz (7) mit einem Trägerabschnitt zum Halten der Platinenanordnung (2),
- Lichtquelle mit einer Lichtoptik (3), einen Lichtsensor (4) mit einer Sensoroptik (5) sowie optional eine Spot-Diode mit einer Spot-Diodenoptik (6'),
- bevorzugt ein Optikgestell (11) zum Halten optischer Bauelemente sowie ein Steckelement (8) zum Koppeln der Sensoranordnung mit einer externen Elektronik.

Die Platinenanordnung (2) ist um einen Trägerabschnitt verklappt und dadurch in platzsparender Weise beidseitig mit diesem verbunden und von diesem gehalten.

Die Sensoranordnung (1) ist in ein Gehäuse eingeführt.

Die Erfindung betrifft weiterhin ein Verfahren zum Zusammenfügen eines Time-of-Flight-Sensormoduls.

## Beschreibung

Die Erfindung betrifft ein Time-of-Flight-Sensormodul. Die Erfindung betrifft weiterhin ein Verfahren zum Zusammenfügen eines Time-of-Flight-Sensormoduls.

Time-of-Flight-Sensoranordnungen, die oft auch unter dem Begriff der Time-of-Flight-Kamera bekannt sind, werden häufig als 3D-Kamerasystem genutzt. Die Funktionsweise der Time-of-Flight-Sensoranordnungen beruht auf der Laufzeitmessung von Licht. Es wird mittels eines Leuchtmittels der Time-of-Flight-Sensoranordnung eine abzubildende Szenerie pulsweise ausgeleuchtet. Das emittierte, an der Szenerie reflektierte und wieder zu der Time-of-Flight-Sensoranordnung gelangte Licht wird erfasst. Die Laufzeit des Lichts wird bestimmt. Aus den ermittelten Laufzeitinformationen wird eine Abbildung der ausgeleuchteten Szenerie berechnet. In vielen Fällen wird zur Erfassung des reflektierten Lichts ein zweidimensionaler Lichtsensor, beispielweise ein CCD-Lichtsensor, genutzt. Auf Basis der zweidimensional erfassten Laufzeitinformationen können dreidimensionale Abbildungen der ausgeleuchteten Szenerie abgeleitet werden.

Time-of-Flight-Sensoranordnungen, oft auch als TOF-Sensoranordnungen abgekürzt, weisen viele Vorteile auf. TOF-Sensoranordnungen sind in konstruktiv vergleichsweise einfacher Weise ausbildbar. Nicht zuletzt können TOF-Sensoranordnungen ohne bewegliche Teile auskommen, was eine hohe Verfügbarkeit und vergleichsweise geringe Anfälligkeit von TOF-Sensoranordnungen für mechanische Schäden begünstigt. Weitere Vorteile von TOF-Sensoranordnungen sind ihre hohe Bilderfassungsgeschwindigkeit und ihre hohe Zuverlässigkeit bei Bilderfassung bei einer Vielzahl von möglichen, abzubildenden, Oberflächen.

TOF-Sensoranordnungen haben, nicht zuletzt aufgrund der oben genannten Vorteile, eine Vielzahl von Anwendungen gefunden. Ein wichtiges Feld der Anwendungen von TOF-Sensoranordnungen ist die Automobilindustrie, insbesondere in den Bereichen der Fahrassistenz- und Sicherheitssysteme. Auch Systeme für Gestenerkennungen werden in vielen Fällen unter Nutzung von TOF-Sensoranordnungen ausgestattet.

Vor dem Hintergrund der Nutzung von TOF-Sensoranordnungen in unterschiedlichen Anwendungen besteht der Bedarf nach universell verwendbaren TOF-Modulen, die bei möglichst hoher Abbildungsqualität effizient und kostengünstig herstellbar sind.

Die Aufgabe wird mit einem Time-of-Flight-Sensormodul mit den Merkmalen des Anspruchs 1 gelöst. Die Aufgabe wird weiterhin mit einem Verfahren zum Zusammenfügen eines TOF-Sensormoduls mit den Merkmalen des Anspruchs 12 gelöst.

Vorteilhafte Weiterbildungen ergeben sich aus den Unteransprüchen.

Es ist ein Time-of-Flight-Sensormodul vorgesehen.

Bevorzugt bezieht sich der Begriff des Moduls darauf, dass alle Bauteile umfasst sind, welche - gegebenenfalls mit einer Unterstützung durch extern eingebrachte Stromversorgung und/oder Steuerungskapazität - für einen Betrieb des Time-of-Flight-Sensormoduls erforderlich sind.

Das Sensormodul weist eine Platinenanordnung mit einem Optikbereich und einem Elektronikbereich auf. In dem Optikbereich sind insbesondere, jedoch nicht unbedingt ausschließlich, die optischen Bauelemente des Time-of-Flight-Sensormoduls angeordnet. In dem Elektronikbereich sind insbesondere, allerdings nicht unbedingt ausschließlich, elektronische Bauelemente des Time-of-Flight-Sensormoduls vorgesehen. Der Optikbereich und der Elektronikbereich sind mittels einer Schwenkverbindung mechanisch miteinander verbunden. Mit anderen Worten sind als Bestandteile der Platinenanordnung wenigstens zwei Platinenbereiche vorgesehen, welche eingeschränkt gegeneinander beweglich sind, nämlich mittels Schwenkens. Bevorzugt sind der Optikbereich und der Elektronikbereich der Platinenanordnung jeweils als starre Platine vorgesehen und die Schwenkverbindung als flexible Anordnung bereitgestellt, welche beispielsweise von einer Kante des Optikbereichs zu einer Kante des Elektronikbereichs führt und dadurch eine als Einbauteil vorliegende Platinenanordnung ermöglicht. Ein Schwenken kann dabei ein Verkippen von nur wenigen Grad umfassen, bevorzugt ermöglicht das Schwenken aber ein Verklappen der zwei Platinenbereiche um mindestens 180 Grad.

Das TOF-Sensormodul weist einen Moduleinsatz auf. Der Moduleinsatz dient dazu und ist eingerichtet, die Platinenanordnung an einem Trägerabschnitt des Moduleinsatzes zu halten. Bei dem Halten der Platinenanordnung durch den Trägerabschnitt ist die Platinenanordnung derart mittels ihrer Schwenkverbindung verklappt, dass der Optikbereich an einer ersten Seite des Trägerabschnitts mit dem Trägerabschnitt verbunden ist und der Elektronikbereich an einer zweiten Seite des Trägerabschnitts mit dem Trägerabschnitt verbunden ist. Der Trägerabschnitt ist somit zumindest teilweise zwischen dem Optikbereich und dem Elektronikbereich angeordnet. Mit anderen Worten: Zumindest ein Teil des Trägerabschnitts wird von der Platinenanordung ummantelt, indem Optikbereich und Elektronikbereich um diesen Teil des Trägerabschnitts herum gefaltet sind.

Dadurch, dass die Platinenanordnung als schwenkbare Kopplung wenigstens zweier Platinenbereiche, nämlich des Optikbereichs und des Elektronikbereichs, ausgeführt ist, wird eine besonders platzsparende Anordnung der Platinenanordnung innerhalb des Gehäuses des Time-of-Flight-Sensormoduls ermöglicht. Dadurch, dass mittels der Schwenkverbindung der Optikbereich und der Elektronikbereich schwenkbar miteinander gekoppelt sind, wird eine Anordnung von Optikbereich und Elektronikbereich in einer den Trägerabschnitt umgreifenden Weise ermöglicht. Dies geht mit einer Bauraum sparenden Anordnung der Platinenanordnung an dem Trägerabschnitt einher. Auch kann die Zahl und/oder die räumliche Erstreckung des Trägerabschnittes geringer sein, da eine vergleichbar große Platinenfläche kompakt befestigt und positioniert ist. Einhergehend mit der Befestigung der Platinenanordnung an zwei Seiten des Trägerabschnitts, nämlich an der ersten Seite des Trägerabschnitts und an der zweiten Seite des Trägerabschnitts, und mit der die Platinenabschnitte der Platinenanordnung verbindenden Schwenkverbindung wird ein hohes Maß an mechanischer Stabilität herbeigeführt, welches die Widerstandsfähigkeit des Time-of-Flight-Sensormoduls, insbesondere gegen mechanische Einflüsse, in vorteilhafter Weise begünstigt.

Nicht zuletzt ermöglicht die Bereitstellung einer Kombination Platinenanordnung mit zumindest zwei zueinander schwenkbaren Platinenbereichen eine hohe Flexibilität beim Zusammensetzen des Time-of-Flight-Sensormoduls. Beispielsweise kann jede der beiden Platinen im entklappten Zustand der Platinenanordnung komfortabel mit beispielsweise elektronischen oder optischen Bauelementen versehen werden, ohne dass die Zugänglichkeit aufgrund der kompakten Anordnung im verklappten Zustand eingeschränkt wäre. Nach dem Anordnen der optischen beziehungsweise elektronischen Bauelemente auf der Platinenanordnung kann sodann durch das Verklappen des Optikbereichs zu dem Elektronikbereich hin eine besonders bauraumsparende Verbindung der Platinenanordnung mit dem Trägerabschnitt herbeigeführt werden, wie er bei dem erfindungsgemäßen Time-of-Flight-Sensormodul in vorteilhafter Weise vorliegt.

Auf dem Optikbereich sind zumindest eine Lichtquelle und ein Lichtsensor angeordnet. Sowohl Lichtquelle als auch Lichtsensor sind von dem Trägerabschnitt wegweisend orientiert. Mit anderen Worten: Eine Emission von Licht aus der Lichtquelle erfolgt in eine von dem Trägerabschnitt wegweisende Richtung und der Lichtsensor erfasst Lichtstrahlung aus einem Halbraum, der nicht oder nahezu nicht den Trägerabschnitt umfasst. Durch diese Konfiguration wird die Abbildung einer Szenerie ermöglicht, die im optischen Sinne vor dem Time-of-Flight-Sensormodul vorliegt.

Weiterhin ist auf dem Optikbereich ein Optikgestell vorgesehen, welches eine Lichtoptikfassung und/oder eine Sensoroptikfassung aufweist. Die Lichtoptikfassung hält eine Lichtoptik und ist vor der Lichtquelle positioniert. Die Sensoroptikfassung hält eine Sensoroptik und ist vor dem Lichtsensor positioniert. Lichtoptik und Sensoroptik sind derart vor Lichtquelle und Sensoroptik positioniert, dass die (im optischen Sinne) vor dem Time-of-Flight-Sensormodul befindliche Szenerie bei deren Abbildung durch das Time-of-Flight-Sensormodul unter Miteinbeziehung der vom Fachmann ausgewählten Lichtoptik ausgeleuchtet beziehungsweise Sensoroptik abgebildet wird. Dadurch, dass auf dem Optikbereich ein Optikgestell angeordnet ist, eignet sich das TOF-Sensormodul, nicht zuletzt in Zusammenwirkung mit der vorhandenen Schwenkverbindung der Platinenanordnung, für einen besonders zügigen und effizienten Zusammenbau und eine Konfiguration mit einem hohen Maß an Kompaktheit und Universalität.

Das Time-of-Flight-Sensormodul weist weiterhin ein Gehäuse auf, an welchem der Moduleinsatz derart angeordnet ist, dass der Trägerabschnitt mit den an dem Trägerabschnitt angeordneten optischen und elektronischen Bauelementen innerhalb des Gehäuses befindlich ist. Das Gehäuse und der Moduleinsatz sind bevorzugt derart aufeinander angepasst, dass eine Außenfläche des Moduleinsatzes und das Gehäuse nach Einführen des Moduleinsatzes in das Gehäuse ein vollständig oder im Wesentlichen vollständig geschlossenes Gebilde bilden, welches als ein kompaktes Time-of-Flight-Sensormodul fungiert.

Insbesondere kann vorgesehen sein, dass eine Seitenfläche des Moduleinsatzes eine Öffnung des Gehäuses umlaufend abschließt, um eine Gehäuseöffnung zu schließen. Mit anderen Worten können also Teile des Moduleinsatzes gemeinsam mit dem Gehäuse eine äußere Umhüllung der wesentlichen funktionellen Bestandteile des TOF-Sensormoduls bilden, wenn der Moduleinsatz im Gehäuse eingeführt ist.

Der Trägerabschnitt des Moduleinsatzes und die an dem Trägerabschnitt angeordneten Bauelemente sind dabei derart auf Gehäuse und Moduleinsatz angepasst, dass die optisch und elektronisch wirkenden Elemente des Time-of-Flight-Sensormoduls, insbesondere die Platinenanordnung, die Lichtquelle, der Lichtsensor und das Optikgestell mit Lichtoptikfassung, Lichtoptiksensorfassung und Sensoroptik innerhalb des abgeschlossenen Gehäuses befindlich sind.

Bevorzugt sind Ausgestaltungen, in denen auf dem Elektronikbereich eine zumindest mit der Lichtquelle und dem Lichtsensor gekoppelte Steuereinrichtung angeordnet ist. Die Steuereinrichtung kann beispielsweise eigenständig oder in Zusammenwirkung mit einer externen Steuereinheit die Ansteuerung von Lichtquelle und Lichtsensor vornehmen und/oder die Auswertung der von dem Lichtsensor erfassten Daten unterstützen oder alleine vornehmen. Die Steuereinrichtung kann beispielsweise als Mikrocontroller ausgebildet sein. Alternativ oder zusätzlich kann eine Steuereinheit auf dem Optikbereich angeordnet sein.

In einer bevorzugten Ausführungsform sind Optikbereich und Elektronikbereich als starre Platinenabschnitte ausgebildet und die Schwenkverbindung umfasst flexible Verbindungselemente. Dadurch wird erreicht, dass der Optikbereich und der Elektronikbereich, die am Trägerabschnitt des Moduleinsatzes befestigt sind, zur Stabilisierung des Trägerabschnittes und damit des gesamten Time-of-Flight-Sensormoduls beitragen.

In einer Weiterbildung kann die Schwenkverbindung ein elektrisches Leitelement umfassen, so dass eine elektrische Kopplung zwischen Optikbereich und Elektronikbereich teilweise oder vollständig innerhalb der Schwenkverbindung angeordnet ist. Ein weiteres, gegebenenfalls nachträgliches, elektrisches Koppeln von Optikbereich und Elektronikbereich kann dadurch teilweise oder vollständig entbehrlich sein.

Gemäß einer weiteren vorteilhaften Weiterbildung der Erfindung kann vorgesehen sein, dass der Optikbereich eine Anzahl von Stecklöchern aufweist, in welche korrespondierende Steckstifte eingeführt sind. Die Steckstifte sind an der ersten Seite des Trägerabschnitts angeordnet. Mit anderen Worten weist der Trägerabschnitt der ersten Seite Steckstifte auf, die in Stecklöchern des Optikbereichs eingeführt sind und den Optikbereich dadurch mit dem Trägerabschnitt verbinden. Die Steckstifte können beispielsweise mittels Heißverstemmens und/oder mittels Kleben in den Stecklöchern befestigt sein, aber auch andere Verbindungsprinzipien, beispielsweise Reibschluss oder Kraftschluss, können alternativ oder zusätzlich vorgesehen sein.

Alternativ oder zusätzlich können Weiterbildungen vorgesehen sein, in denen der Elektronikbereich der Platinenanordnung eine Anzahl von Stecklöchern aufweist, in die korrespondierende Steckstifte eingeführt der zweiten Seite des Trägerabschnitts eingeführt sind.

Bevorzugt weisen sowohl die erste Seite als auch die zweite Seite des Trägerabschnitts Steckstifte auf, wobei die Steckstifte der ersten Seite und die Steckstifte der zweiten Seite in voneinander wegweisender Richtung orientiert sind. Eine derartige Konfiguration hat den Vorteil, dass bei einem Klappen der Platinenanordnung um den Trägerabschnitt herum sowohl der mit entsprechenden Stecklöchern versehene Optikbereich als auch der mit entsprechenden Stecklöchern versehene Elektronikbereich mit dem Trägerabschnitt verbunden werden kann, wodurch eine besonders stabile und langlebige Verbindung zwischen Platinenanordnung und Moduleinsatz vorliegt.

Der Optikbereich der Platinenanordnung kann alternativ oder zusätzlich eine Anzahl von Aufnahmelöchern aufweisen in denen korrespondierende Haltestifte des Optikgestells eingeführt sind. Bevorzugt ist, dass das Optikgestell an einer anderen Seite der beiden Flächen des Optikbereichs angeordnet wird als der Trägerabschnitt, so dass das Optikgestell vor den optischen Bauelementen, insbesondere Lichtquelle und Lichtsensor, angeordnet ist.

Bevorzugt ist, dass an der ersten Seite des Trägerabschnitts wenigstens drei Steckstifte der ersten Seite angeordnet sind, wobei wenigstens ein erster Steckstift und ein zweiter Steckstift der an der ersten Seite angeordneten Steckstifte als Quetschrippen aufweisende Positionierstifte ausgebildet sind. Die Positionierstifte sind gemeinsam mit dem korrespondierenden ersten Steckloch und dem korrespondierenden zweiten Steckloch derart aufeinander abgestimmt dimensioniert und positioniert, dass die Quetschrippe des ersten Steckstifts und die Quetschrippen des zweiten Steckstifts der ersten Seite eine kraftschlüssige Verbindung zwischen Trägerabschnitt und Optikbereich herbeiführen. Wenigstens ein dritter Steckstift der ersten Seite korrespondiert derart mit einem dritten Steckloch des Optikbereichs, dass das dritte Steckloch des Optikbereichs gegenüber dem dritten Steckstift der ersten Seite ein Übermaß aufweist und dadurch eine Positionierungstoleranz bereitstellt.

Das Bereitstellen der Positionierungstoleranz ist dahingehend zu verstehen, dass die oben erläuterte relative Positionierung und die Dimensionierung von Stecklöchern und Steckstiften dazu führt, dass die Quetschrippen aufweisenden Steckstifte die Positionierung des Optikbereichs festlegen. Die aus den Übermaßen der Stecklöcher resultierende Toleranz wird hingegen für einen Ausgleich von bei der Fertigung der einzelnen Bauteile, in diesem Fall von Optikbereich und Trägerabschnitt, tolerierten Abweichungen genutzt. Aufgrund der vorliegenden Positionierungstoleranz ist in den meisten Fällen eine problemlose Einführung der Steckstifte in die Stecklöcher möglich. Die Steckstifte, die keine Quetschrippen aufweisen, dienen nicht primär der Befestigung des Optikmoduls sondern vielmehr einem Führen zur vereinfachten Montage, wobei optional zusätzliches stoffschlüssiges Fügen, beispielsweise mittels Klebens, ergänzend genutzt werden kann.

In analoger Weise kann alternativ oder zusätzlich vorgesehen sein, dass an der zweiten Seite des Trägerabschnitts wenigstens drei Steckstifte der zweiten Seite angeordnet sind. Wenigstens ein erster Steckstift und ein zweiter Steckstift der an der zweiten Seite angeordneten Steckstifte sind als Quetschrippen aufweisende Positionierstifte ausgebildet, die derart mit einem korrespondierenden ersten Steckloch und zweiten Steckloch des Elektronikbereichs zusammenwirken, dass die Quetschrippe des ersten Steckstifts und des zweiten Steckstifts der zweiten Seite eine kraftschlüssige Verbindung zwischen Trägerabschnitt und Elektronikbereich herbeiführen. Ein zusätzlich vorgesehener dritter Steckstift der zweiten Seite korrespondiert derart mit einem dritten Steckloch des Elektronikbereichs, dass ein Übermaß des dritten Stecklochs des Elektronikbereichs gegenüber dem dritten Steckstift der zweiten Seite eine Positionierungstoleranz bereitstellen.

Alternativ oder zusätzlich kann an der Unterseite des Optikgestells eine Anzahl von Haltestiften, bevorzugt wenigstens vier Haltestiften, vorgesehen sein, wobei wenigstens ein erster und ein zweiter der an der Unterseite des Optikgestells vorgesehenen Haltestiften Quetschrippen aufweisen, die derart mit korrespondierenden ersten und zweiten Aufnahmeloch des Optikbereichs zusammenwirken, so dass die Quetschrippe des ersten Haltestifts und die Quetschrippe des zweiten Haltestifts eine kraftschlüssige Verbindung zwischen Optikgestell und Optikbereich herbeiführen. Zumindest ein dritter Haltestift dient der Unterstützung bei Positionierung des Optikgestells, wobei in Zusammenwirkung mit einem korrespondierenden dritten Aufnahmeloch infolge eines Übermaßes des dritten Aufnahmelochs gegenüber dem korrespondierenden dritten Haltestift eine Positionierungstoleranz vorliegt, mit der tolerierte und unvermeidliche Fertigungsabweichungen des Optikgestells ausgeglichen werden.

Die Stecklöcher und/oder Aufnahmelöcher weisen ein Übermaß auf. Eine Befestigung erfolgt mit einer Untermenge der vorhandenen Steckstifte beziehungsweise Haltestifte. Dadurch wird die Möglichkeit bereitgestellt, bei der Fertigung der einzelnen verbundenen Bauelemente - wie insbesondere der Platinenanordnung, dem Trägerabschnitt und dem Optikgestell - Fertigungsabweichungen zulassen zu können. Durch das ermöglichte Zulassen von Fertigungsabweichungen ist die Fertigung der genannten Bauelemente weniger aufwendig und dadurch potenziell kostengünstiger möglich. Zudem werden eventuelle Nacharbeiten bei der Verbindung der genannten Bauelemente vermieden oder weitgehend vermieden, so dass auch das Fügen der genannten Bauelemente vergleichsweise unaufwendig ist.

Bevorzugt ist das Optikgestell als einstückiges Bauteil ausgebildet, so dass die Anzahl der insgesamt vorliegenden Bauelemente reduziert wird. Durch diese Maßnahme werden die Gesamtkosten einer Herstellung de TOF-Sensormoduls potentiell reduziert.

In einer bevorzugten Ausgestaltung des TOF-Sensormoduls weist der Moduleinsatz an einer Endfläche ein Steckelement auf, durch welches hindurch eine elektrische Verbindung von einem Gehäuseäußeren zu einem Gehäuseinneren geführt ist. Dieses Steckelement kann beispielsweise dazu dienen, eine Kopplung des TOF-Sensormoduls mit einer fahrzeugseitigen Energiequelle und/oder Steuereinrichtung vorzunehmen. Das Steckelement kann beispielsweise als röhrenförmiger Fortsatz eines Lochs im Moduleinsatz ausgebildet sein, der sich vom Moduleinsatz ausgehend in eine vom Gehäuseinneren wegweisende Richtung erstreckt.

Bevorzugt ist es, wenn das der Moduleinsatz eine Führungsausformung aufweist, die in eine Komplementärausformung des Gehäuses geführt ist. Beispielsweise kann es sich bei der Führungsausformung um einen Gleitvorsprung handeln, der in eine als Nut ausgebildete Komplementärausformung des Gehäuses eingeführt wird. Bevorzugt ist die Führungsausformung einstückiger Bestandteil des Trägerabschnitts. Beispielsweise kann es sich bei der Führungsausformung um einen flügelartigen Vorsprung handeln, der sich an dem Trägerabschnitt in eine zum Optikbereich parallele Richtung erstreckt. Eine Führungsausformung und eine auf die Führungsausformung angepasste Komplementärausformung erleichtern das Einführen des Moduleinsatzes in das Gehäuse und/oder das Ausführen des Moduleinsatzes aus dem Gehäuse. Eine derart ausgebildete Weiterbildung der Erfindung ist komfortabel fügbar und, beispielsweise für Reparaturzwecke, auseinanderzubauen. Ein Resultat sind nicht zuletzt sinkende Zusammenbau- und/oder Servicekosten.

In einer bevorzugten Ausgestaltung der Erfindung sind ein Gehäuseäußeres und die Platinenanordnung mittels eines Zwischenelements miteinander elektrisch koppelbar. Bevorzugt erstreckt sich ein Abschnitt des Zwischenelements in das Steckelement hinein. Das Vorsehen eines Zwischenelements hat den Vorteil, dass für eine Kopplung von Gehäuseäußerem und Platine eine entsprechende Anpassung der Kopplung vorgenommen werden kann, beispielsweise für unterschiedliche extern vorliegende Steckertypen, ohne dass die sonstigen Bauelemente, beispielsweise die Platinenanordnung, ebenfalls angepasst werden müssen. Dadurch wird ein hohes Maß an universeller Verwendbarkeit erreicht.

In einer Ausgestaltung kann vorgesehen sein, dass auf dem Optikbereich eine Spot-Diode zum Markieren eines Erfassungsbereichs des TOF-Sensormoduls auf einer Projektionsfläche angeordnet ist. Ergänzend dazu weist in dieser Ausgestaltung das Optikgestell bevorzugt eine Spot-Dioden-Optik-Ausnehmung auf, in welcher eine Spot-Dioden-Optik eingeführt ist.

Der Lichtsensor kann beispielsweise einen CCD-Chip aufweisen. Die Lichtquelle ist bevorzugt als Laserdiode ausgebildet oder weist eine Laserdiode auf.

Die Lichtquelle kann sichtbares und/oder unsichtbares Licht ausstrahlen. Bevorzugt ist jedoch die Nutzung von Lichtquellen, insbesondere Laserdioden, die Licht mit einer Wellenlänge des nahen infraroten Wellenlängenbereichs emittieren, also beispielsweise mit einer oder mehreren Wellenlängen aus dem Bereich zwischen 0,78 Mikrometern und 3,0 Mikrometern.

Ein weiterer Gedanke der Erfindung sieht ein Verfahren zum Zusammenfügen eines Time-of-Flight-Sensormoduls vor. Das Verfahren sieht die folgenden Schritte vor:
Ein Optikgestell wird auf einem Optikbereich einer Platinenanordnung angeordnet, bevorzugt mit dieser verbunden. Die Platinenanordnung trägt eine Lichtquelle und einen Lichtsensor, bevorzugt zusätzlich eine Spot-Diode. Das Optikgestell dient der Bereitstellung einer Lichtoptikfassung und/oder einer Sensoroptikfassung.

Das Verfahren sieht außerdem den Schritt vor, dass eine Lichtoptik in der Lichtoptikfassung und eine Sensoroptik in der Sensoroptikfassung angeordnet werden.

Der Optikbereich der Platinenanordnung wird mit einer ersten Seite eines Trägerabschnitts eines Moduleinsatzes verbunden, indem Steckstifte der ersten Seite in korrespondierend angeordnete Stecklöcher des Optikbereichs geführt werden.

Ein Elektronikbereich der Platinenanordnung wird mit einer zweiten Seite des Trägerabschnitts des Moduleinsatzes verbunden, der auf einer der ersten Seite abgewandten zweiten Seite des Trägerabschnitts liegt. Das Verbinden erfolgt, indem Steckstifte der zweiten Seite in korrespondierend angeordnete Stecklöcher des Elektronikbereichs geführt werden. Der Elektronikbereich wird vor dem Verbinden mittels einer Schwenkverbindung der Platinenanordnung geklappt, welche den Optikbereich mit dem Elektronikbereich verbindet und zwischen diesen angeordnet ist. Dadurch, dass der Elektronikbereich und der Optikbereich relativ zueinander verklappt werden, wird der Trägerabschnitt zumindest teilweise zwischen dem Optikbereich und dem Elektronikbereich positioniert. Mit anderen Worten: Es wird insbesondere ermöglicht, dass der Trägerabschnitt mit dem Optikbereich und dem Elektronikbereich zwei, alternativ auch mehr als zwei, miteinander verbundene Abschnitte der Platinenanordnung trägt. Optikbereich und Elektronikbereich sind an zwei voneinander weg weisenden Seiten des Trägerabschnitts anliegend positioniert. Dadurch sind sie in gestapelter und damit besonders platzsparender Weise angeordnet.

Der Moduleinsatz wird in ein Gehäuse eingeführt, welches zur Aufnahme des Moduleinsatzes eingerichtet ist. Das Gehäuse weist hierzu eine Aufnahmeöffnung auf, in welche hinein der Moduleinsatz, bevorzugt mit seinem Trägerabschnitt, in das Gehäuse eingeführt wird. Nach Einführen des Moduleinsatzes in das Gehäuse befindet sich der Trägerabschnitt bevorzugt entlang seiner gesamten Erstreckung inklusive aller mittelbar oder unmittelbar mit dem Trägerabschnitt verbundener Bauelemente innerhalb des Gehäuses und damit in einem vor äußeren Einflüssen beispielsweise durch mechanische Einwirkungen geschützten Bereich.

Bevorzugt wird bei dem Anordnen des Optikgestells auf dem Optikbereich eine Anzahl von Haltestiften, die an der Unterseite des Optikgestells angeordnet ist, in Aufnahmelöcher des Optikbereichs eingeführt. Die Aufnahmelöcher des Optikbereichs sind zur Aufnahme der Haltestifte des Optikgestells entsprechend dimensioniert und positioniert. Wenigstens ein erster Haltestift und ein zweiter Haltestift sind mit Quetschrippen versehen, die beim Einführen in die korrespondierenden Aufnahmelöcher eine kraftschlüssige Befestigung des Optikgestells an dem Optikbereich bewirken. Ein zumindest noch vorhandener weiterer Haltestift und ein weiteres korrespondierendes Aufnahmeloch des Optikbereichs werden ineinander geführt. Das Aufnahmeloch ist dabei im Verhältnis zum Haltestift mit einem Übermaß ausgestattet derart, dass für den Haltestift eine Positionierungstoleranz bereitgestellt ist. Bevorzugt weisen genau zwei der Haltestifte des Optikbereichs Quetschrippen auf. Dadurch wird eine Bereitstellung einer großen Positionierungstoleranz erreicht.

Der Platinenabschnitt wird bevorzugt derart mittels der Schwenkverbindung geklappt, dass der Optikbereich an der ersten Seite des Trägerabschnitts anliegend und der Elektronikbereich an der zweiten Seite des Trägerabschnitts anliegend mit dem Trägerabschnitt verbunden wird. Besonders bevorzugt ist eine Ausgestaltung, in welcher ein an der ersten Seite des Trägerabschnitts angeordneter erster Steckstift und ein zweiter Steckstift der ersten Seite in korrespondierendes erstes Steckloch und zweites Steckloch des Optikbereichs eingeführt werden, wobei Quetschrippen des ersten Steckstifts und Quetschrippen des zweiten Steckstifts der ersten Seite eine kraftschlüssige Verbindung zwischen Trägerabschnitt und Optikbereich herbeiführen oder wenigstens unterstützen. Ein dritter Steckstift der ersten Seite wird in ein drittes Steckloch des Optikbereichs eingeführt, wobei das dritte Steckloch gegenüber dem dritten Steckstift der ersten Seite eine Positionierungstoleranz bereitstellt. Eine endgültige Fixierung des Optikbereichs an dem Trägerabschnitt kann optional mittels weiterer Mittel vorgenommen werden, beispielsweise mittels eines Klebers wie insbesondere einem UV-härtenden Kleber.

Alternativ oder zusätzlich kann analog ein an der zweiten Seite des Trägerabschnitts angeordneter erster Steckstift und ein zweiter Steckstift der zweiten Seite in korrespondierende erste und zweite Stecklöcher des Elektronikbereichs eingeführt werden, so dass Quetschrippen des ersten Steckstifts und Quetschrippen des zweiten Steckstifts der zweiten Seite eine kraftschlüssige Verbindung zwischen Trägerabschnitt und Elektronikbereich herbeiführen oder zumindest unterstützen. Wenigstens ein dritter Steckstift der ersten Seite wird in ein drittes Steckloch des Elektronikbereichs eingeführt. Ein Übermaß des dritten Stecklochs des Elektronikbereichs gegenüber dem dritten Steckstift der zweiten Seite stellt eine Positionierungstoleranz bereit.

In einer besonders bevorzugten Ausgestaltung kann vorgesehen sein, dass ein Zwischenelement mit einem ersten Endabschnitt mit dem Optikbereich und/oder mit dem Elektronikbereich elektrisch gekoppelt wird und mit einem zweiten Endabschnitt in ein Steckelement des Moduleinsatzes eingeführt wird. Das Zwischenelement dient dabei der Bereitstellung einer elektrischen Verbindung von einem Gehäuseinneren zu dem Gehäuseäußeren.

Gemäß einer bevorzugten Ausgestaltung ist vorgesehen, dass der Trägerabschnitt des Moduleinsatzes mit den an dem Trägerabschnitt angeordneten Bauelementen des TOF-Sensormoduls in das Gehäuse eingeführt wird. Eine Führungsausformung des Trägerabschnitts und eine Komplementärausformung des Gehäuses bewirken dabei eine Gleitführung des Moduleinsatzes hin zu der Kopplungsposition des TOF-Sensormoduls.

Die erläuterten Verfahren sind insbesondere auch für ein Zusammenfügen eines Time-of-Flight-Sensormoduls der eingangs beschriebenen Art oder einer seiner Weiterbildungen geeignet. Die mit dem erfindungsgemäßen Verfahren einhergehenden Vorteile sind in analoger Weise auch Vorteile des erfindungsgemäßen Time-of-Flight-Sensormoduls, da dieses in vorteilhafter Weise hergestellt ist. Die bei Erläuterung des TOF-Sensormoduls beschriebenen Vorteile sind in analoger Weise auch für das erfindungsgemäße Verfahren gültig.

Weitere Einzelheiten, Merkmale und Vorteile des Gegenstands der Erfindung ergeben sich aus der nachfolgenden Beschreibung im Zusammenhang mit den Zeichnungen. Die Zeichnungen geben beispielhaft ein Ausführungsbeispiel der Erfindung wieder.

Es versteht sich, dass die vorstehend genannten wie auch die nachfolgend erläuterten Merkmale nicht nur in der jeweils angegebenen Kombination, sondern auch in anderen Kombinationen oder in Alleinstellung verwendbar sind.

Es zeigen:
Figs. 1 bis 5: Teilweise Explosionsdarstellungen und gefügte Darstellungen von einzelnen Bestandteilen eines Ausführungsbeispiels eines erfindungsgemäßen Time-of-Flight-Sensormoduls;
Fig. 6: Time-of-Flight-Sensormodul der Figs. 1 bis 5 in gefügter Form, jedoch ohne Gehäuse;
Fig. 7: Gehäuse und Moduleinsatz des Time-of-Flight-Sensormoduls der Figs. 1 bis 6 in nicht ineinander eingeführter Darstellung;
Fig. 8: Time-of-Flight-Sensormodul der Fig. 7 nach Einführen des Moduleinsatzes in das Gehäuse.

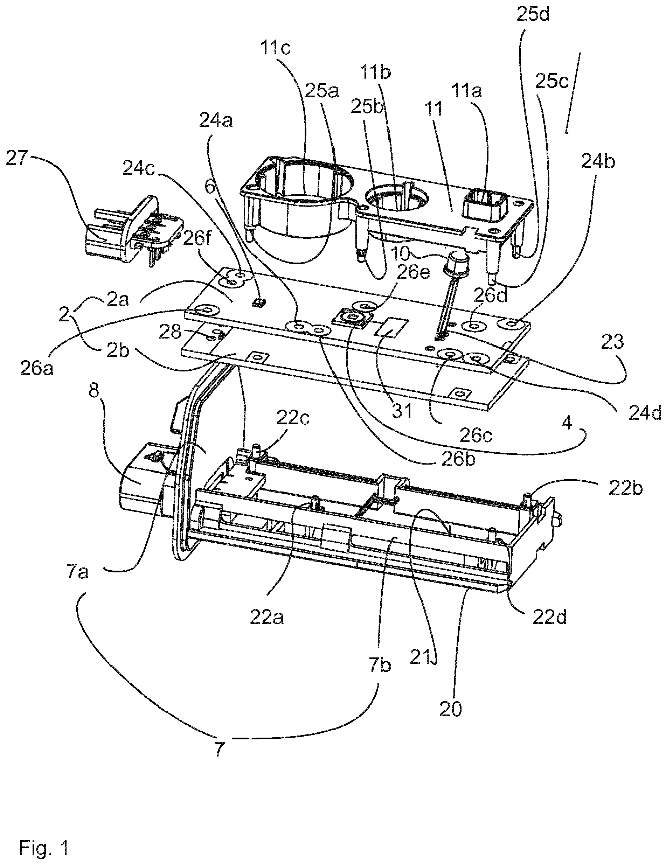

Fig. 1 ist eine Anzahl von Bauelementen einer Ausführungsform eines erfindungsgemäßen Time-of-Flight-Sensormoduls zu entnehmen. Es ist ein Moduleinsatz 7 dargestellt. Der Moduleinsatz 7 weist eine Endfläche 7a auf, an welcher ein Trägerabschnitt 7b angeordnet ist. Der Trägerabschnitt weist eine erste Seite 21 sowie eine zweite, in der gezeigten Darstellung nicht erkennbare, zweite Seite auf. In der gezeigten Darstellung ist die erste Seite 21 die in bei vorgesehener Betrachtung vorliegender Papierorientierung obere Seite und die zweite Seite die der ersten Seite abgewandten Seite des Trägerabschnitts. Die erste Seite 20 ist diejenige Seite, welche der abzubildenden Szenerie bei Verwendung des Time-of-Flight-Sensormoduls im zusammengefügten Zustand zugewandt ist. Der Trägerabschnitt 7a weist vier Steckstifte 22a, 22b, 22c, 22d auf, wobei die Steckstifte 22a, 22b als Quetschrippen aufweisende Positionierstifte ausgebildet sind. Oberhalb der ersten Seite 20 des Trägerabschnitts 7a ist die Platinenanordnung 2 zu entnehmen. Die Platinenanordnung 2 setzt sich aus dem Optikbereich 2a und dem Elektronikbereich 2b zusammen, die beide als starre Platinenabschnitte ausgebildet sind. In der speziellen Ausgestaltung der gezeigten Ausführungsform sind der Optikbereich 2a und der Elektronikbereich 2b als Rechtecke mit gleichen Abmessungen ausgestaltet.

Der Optikbereich 2a und der Elektronikbereich 2b sind mit einer flexiblen, elektrische Leitelemente aufweisenden, Schwenkverbindung miteinander gekoppelt, die allerdings in der Darstellung der Fig. 1a aus perspektivischen Gründen nicht entnehmbar ist. Auf dem Optikbereich ist ein als CCD-Chip ausgebildeter Lichtsensor 4 sowie eine Spot-Diode 6 angeordnet. Beide sind, wie nach seiner Ankopplung an den Optikbereich auch die Lichtquelle, mit einer auf dem Optikbereich angeordneten und als Mikrocontroller ausgebildeten Steuereinheit 31 gekoppelt. Weiterhin sind Verbindungslöcher 23 zum Anordnen einer Lichtquelle vorgesehen. Ferner ist Lichtquelle 10 gezeigt, die in der dargestellten Ausführungsform als Laserdiode ausgebildet ist, aber alternativ auch durch eine LED ergänzt oder ersetzt werden könnte. In den nachfolgenden Figuren ist die Lichtquelle aus Gründen der Übersichtlichkeit nicht mehr dargestellt. Der Optikbereich weist ein erstes Steckloch 24a und ein zweites Steckloch 24b auf, die zur Einbringung der Positionierstifte 22a, 22b vorgesehen sind. Die beiden weiteren Stecklöcher 24c, 24d sind zur Aufnahme der Steckstifte 22c, 22d vorgesehen. Entsprechend sind die Stecklöcher 24c, 24d mit einem Durchmesser ausgestattet, welcher signifikant größer ist, beispielsweise 20 Prozent größer, als der Durchmesser der Steckstifte 22c, 22d. Aufgrund des größeren Durchmessers können Positionierungsabweichungen der Steckstifte 22c, 22d und/oder der Stecklöcher 24c, 24d zumindest teilweise ausgeglichen werden. Das Maß der Abweichungen, welche toleriert oder erwartet werden bzw. zum Ausgleich vorgesehen werden, kann in Abhängigkeit von den zugelassenen oder tolerierten Fertigungstoleranzen, den angestrebten Fügegeschwindigkeiten und/oder der angestrebten Fertigungsqualität ausgewählt werden.

Die Platinenanordnung 2a weist in der gezeigten Darstellung bereits die miteinander verklappten Abschnitte Optikbereich 2a Elektronikbereich 2b auf, die parallel zueinander orientiert sind. Der Optikbereich 2a ist zur Verbindung mit einer ersten Seite 20 des Trägerabschnitts 7b und der Elektronikbereich 2b zur Verbindung mit einer der ersten Seite 20 abgewandt orientierten zweiten Seite 21 des Trägerabschnitts 7b ausgebildet. Selbstverständlich wären, wenn es sich bei Fig. 1 nicht um eine Explosionsdarstellung handelte, für ein Fügen von Optikbereich 2a und Elektronikbereich 2b diese zunächst auseinanderzuklappen und nach einem Anordnen eines der beiden an dem Trägerabschnitt 7b wieder die Platinenanordnung um die Schwenkverbindung zu verklappen. Das Verbinden des Optikbereichs 2a und des Elektronikbereichs 2b mit dem Trägerabschnitt 7b bewirkt, dass der Optikbereich 2a an einer (in der gezeigten Betrachtungsrichtung und der bei Betrachtung vorgesehenen Papierorientierung) Oberseite des Trägerabschnitts 7b anliegt und der Elektronikbereich 2b an einer Unterseite des Trägerabschnitts 7b anliegt.

Dadurch ist zumindest ein Abschnitt des Trägerabschnitts 7b in einer zur Ebenennormale des Optikbereichs 2a parallelen Richtung zwischen dem Optikbereich 2a und dem Elektronikbereich 2b angeordnet. Mit anderen Worten liegt zumindest ein Abschnitt des Trägerabschnitts 7a zwischen einer ersten Ebene, die den Optikbereich 2a umfasst und einer zweiten Ebene, die den Elektronikbereich 2b umfasst.

Das in der gezeigten Darstellung als einstückiges Bauteil ausgebildete Optikgestell 11 stellt eine Lichtoptikfassung 11a bereit, in der eine Lichtoptik eingebracht werden kann. Weiterhin sind eine Sensoroptikfassung 11b für eine Sensoroptik und eine Spot-Diodenoptikfassung für eine Spot-Diodenoptik 11c vorhanden. Für das Einführen der verschiedenen Optikelemente sind entsprechende Nuten oder Federn vorgesehen.

Das Optikgestell weist sechs Haltestifte 25a, 25b, 25c, 25d, 25e, 25f auf, von denen in der gewählten Perspektive jedoch nur die Haltestifte 25a, 25b, 25c, 25d erkennbar sind. Zwei der in der gezeigten Ausgestaltung des Optikgestells vorhandenen Haltestifte 25b, 25e weisen Quetschrippen auf. Die Positionen der Haltestifte 25b und 25e sind auf ein Einführen in die korrespondierenden Aufnahmelöcher 26b und 26e abgestimmt. Die Aufnahmelöcher des Optikbereichs sind entsprechend an die Positionierung und Dimensionierung der Haltestifte des Optikgestells angepasst. Mit den Quetschrippen der Haltestifte 25b und 25e wird beim Einführen der Haltestifte des Optikgestells 11 in die Aufnahmelöcher des Optikbereichs 2a eine zumindest auch kraftschlüssige Verbindung zwischen Optikbereich 2a und Optikgestell 11 herbeigeführt. Die Aufnahmelöcher 26a, 26c, 26d und 26f weisen gegenüber den Haltestiften 25a, 25c, 25d, 25f jeweils ein Übermaß auf, beispielsweise von 20 % im Durchmesser. Mittels dieses Übermaßes der Durchmesser der Aufnahmelöcher wird für das Einbringen der Haltestifte eine Positionierungstoleranz bereitgestellt. Eventuelle Abweichungen in den Maßen des Optikgestells lassen sich entsprechend ausgleichen. Trotz des vorhandenen Übermaßes unterstützen die Haltelöcher 26a, 26c, 26d, 26f durch das Einführen der Haltestifte 25a, 25c, 25d, 25f die Positionierung des Optikgestells 11. Je nach konstruktiver Ausgestaltung kann als ergänzende Maßnahme eine Fixierung mit Hilfe unterstützender Befestigungsmittel vorgenommen werden. Beispielsweise können die Haltestifte mit den Aufnahmelöchern verklebt werden, was beispielsweise mit UV-härtendem Kleber effizient herbeigeführt werden kann.

Zusätzlich zu den bereits genannten Elementen ist noch ein Zwischenelement 27 dargestellt. Das Zwischenelement 27 wird mit einem ersten Endabschnitt mit dem Elektronikbereich 2b galvanisch gekoppelt. Ein zweiter Endabschnitt wird in das Steckelement 8 des Moduleinsatzes 7 eingeführt zur Bereitstellung einer elektrischen Verbindung von einem Gehäuseinneren zu dem Gehäuseäußeren.

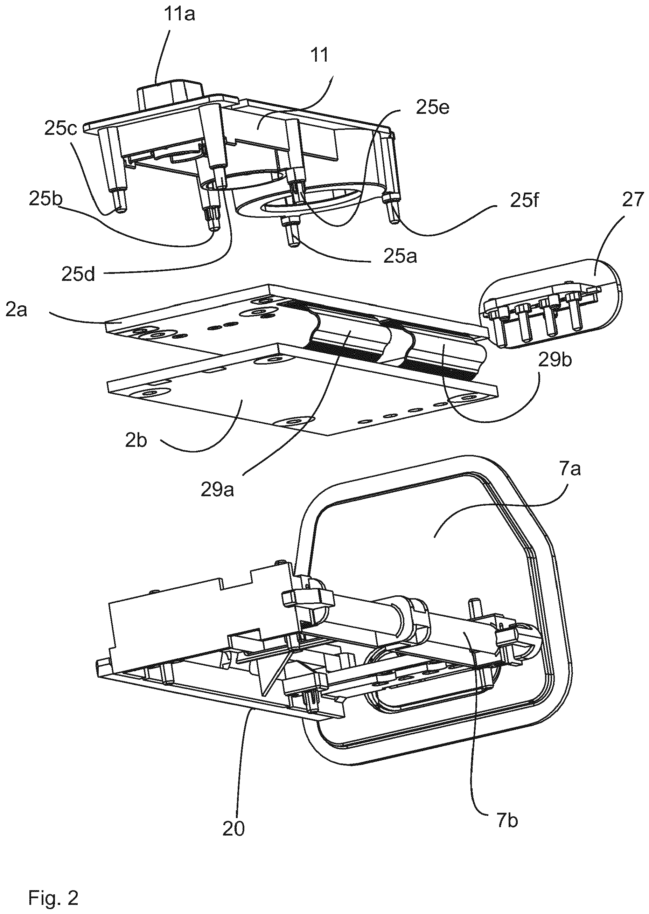

Die Konstellation der Fig. 1 ist in Fig. 2 in einer anderen Perspektive dargestellt. Fig. 2 ist insbesondere noch die Schwenkverbindung 29 zu entnehmen, die aus Schwenkverbindungselementen 29a, 29b ausgebildet ist. Die Schwenkverbindungselemente 29a, 29b sind als dünne, flexible Metallbleche beziehungsweise Metallfolien ausgebildet, wobei optional selbstverständlich auch andere Verbindungselemente vorgesehen sein können, beispielsweise folienverstärkte Schwenkverbindungselemente. Die Schwenkverbindungselemente 29a, 29b weisen jeweils eine elektrische Verbindung zur elektrischen Kontaktierung des Optikbereichs mit dem Elektronikbereich auf.

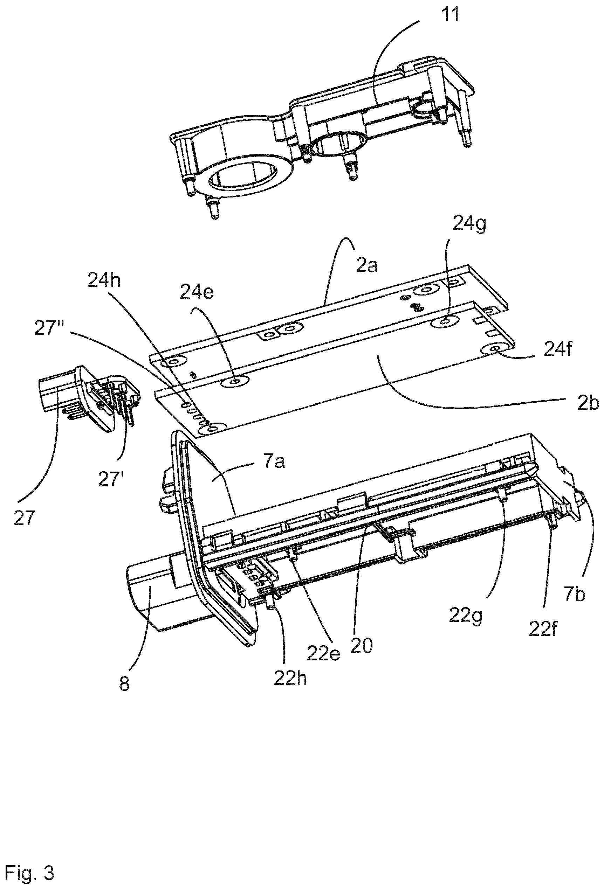

Eine weitere andere perspektivische Darstellung ist Fig. 3 zu entnehmen. In der gezeigten Perspektive sind die Stecklöcher 24e, 24f, 24g, 24h des Elektronikbereichs 2b erkennbar, mit denen der Elektronikbereich mit dem Trägerabschnitt 7b verbunden werden kann. Die Verbindung des Trägerabschnitts 7b erfolgt mittels der Steckstifte 24e, 24f, 24g, 24h des Trägerabschnitts 7b. Die Steckstifte 24e, 24f, 24g, 24h sind parallel zueinander und parallel zu jedem der Steckstifte 24a, 24b, 24c, 24d orientiert. Darüber hinaus wird hinsichtlich der erkennbaren Elemente auf die vorherige Beschreibung verwiesen.

Fig. 3 ist außerdem Zwischenelement 27 zu entnehmen. Dieses weist Anschlussstecker 27' auf zum Anschluss an Aufnahmeöffnungen 27" der Platinenanordnung 2. Die Aufnahmeöffnungen sind in dem gezeigten Ausführungsbeispiel am Optikbereich 2b angebracht. Die Aufnahmeöffnungen dienen einer elektrischen Kontaktierbarkeit der Platinenanordnung 2 mit einem Gehäuseäußeren durch das Steckelement 8 hindurch.

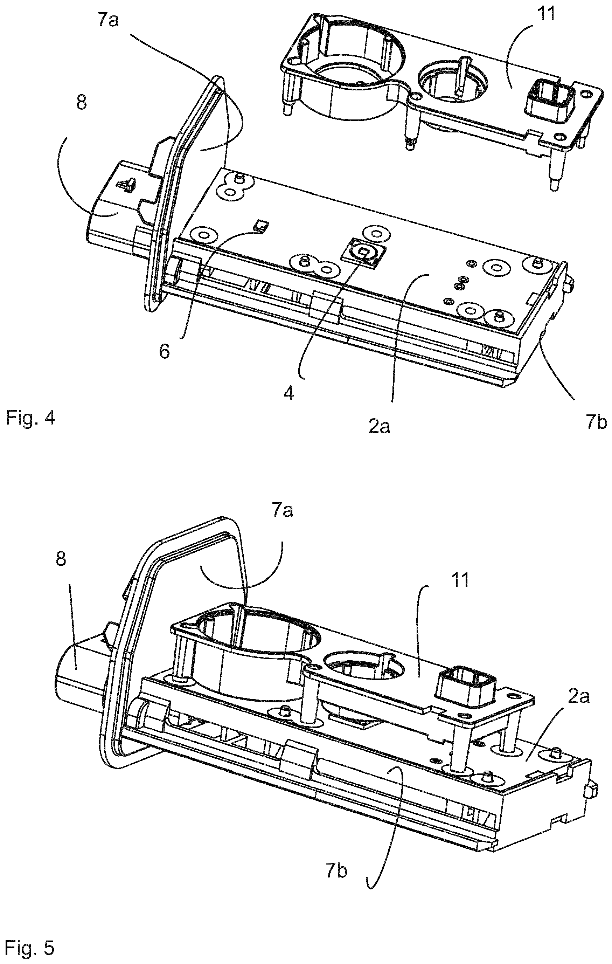

Fig. 4 ist zu entnehmen, wie der Optikbereich 2a mit dem Trägerabschnitt 7b verbunden ist. Der mittels Schwenkverbindung um den Trägerabschnitt geschwenkte Elektronikbereich ist auf der zweiten Seite, in der gezeigten Darstellung der Unterseite, des Moduleinsatzes 7 mit dem Trägerabschnitt 7b verbunden. Die Platinenanordnung 2 ist demnach in einer platzsparenden sowie, nicht zuletzt mechanisch, äußerst widerstandsfähigen und eleganten Weise gekoppelt.

Fig. 5 ist die zusätzliche Kopplung des Optikgestells 11 mit dem Optikbereich 2a der Platinenanordnung 2 zu entnehmen.

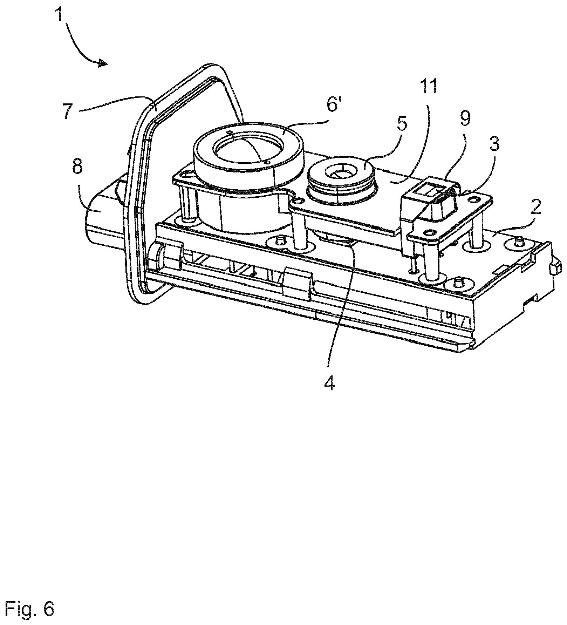

Fig. 6 unterscheidet sich ausgehend von der in Fig. 5 dargestellten Konstellation durch die zusätzliche Anordnung der Lichtoptik 3 in der Lichtoptikfassung, der Sensoroptik 5 in der Sensoroptikfassung und der Spot-Diodenoptik 6' in der Spot-Diodenoptik-Fassung. Die Lichtquelle ist in Fig. 6 nicht zu erkennen, da sie aufgrund der gewählten Abbildungsperspektive von der Lichtoptik 3 ersetzt ist.

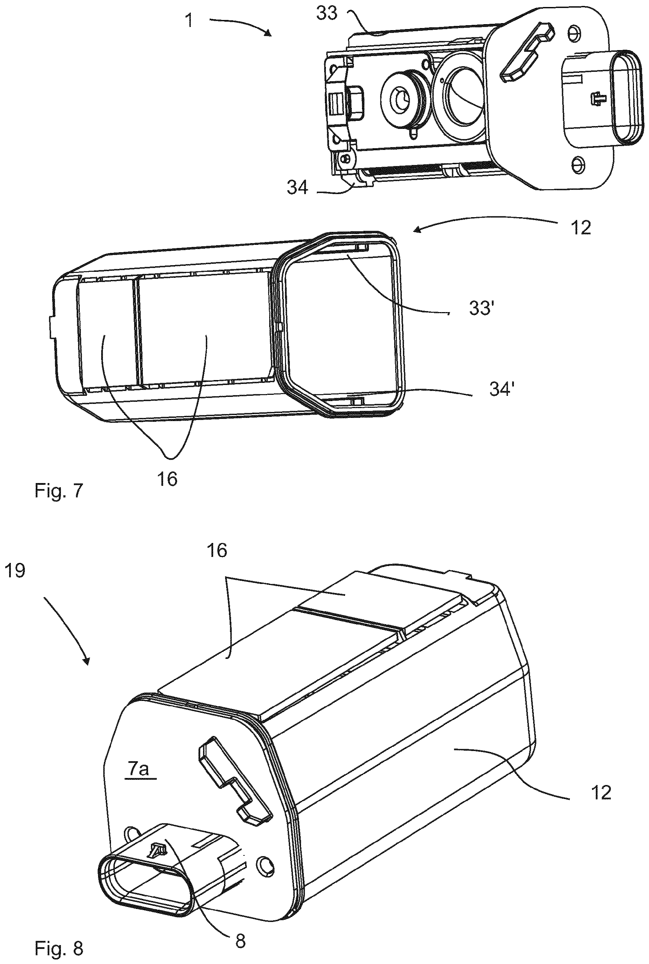

Fig. 7 ist der in Fig. 6 dargestellte, mit sämtlichen erforderlichen Bauelementen bestückte Moduleinsatz 7 gemeinsam mit dem Gehäuse 12 zu entnehmen. Der Moduleinsatz 7 weist zwei parallel zu der Ebene des Optikbereichs wie auch der Ebene des Elektronikbereichs orientierte Erhabungen 33, 34 auf, die als erste Führungsausformung 33 und als zweite Führungsausnehmung 34 fungieren. Das Gehäuse 12 weist in seinem Gehäuseinneren zwei Führungsspuren 33', 34' auf, die komplementär zu Positionierung und Form der Führungsausformungen 33, 34 ausgebildet sind und beim Einführen des Moduleinsatzes 7 in das Gehäuse 12 dieses haltend unterstützen. Fig. 7 ist außerdem noch eine Schutzfensteranordnung 16 zu entnehmen, welche das Gehäuse 12 zum Schutz der Sensoranordnung 1 abschließt, jedoch zur Gewährleistung der optischen Funktionalität in ausreichendem Maß für Licht zumindest der verwendeten Wellenlängen durchlässig ist.

Fig. 8 ist das Gehäuse mit eingeschobenem Moduleinsatz 7 zu entnehmen. Insbesondere ist zu entnehmen, wie die Endfläche 7a das Gehäuse 12 an seiner Gehäuseöffnung diese umlaufend abdichtet. Beispielsweise kann in einer weiteren Variante des Ausführungsbeispiels und/oder allen anderen erfindungsgemäßen Sensormodulen eine Gummilippe vorgesehen sein, die das Gehäuse 12 umläuft und an der Endfläche 7a angeordnet ist.

Der Darstellung der Fig. 8 ist ein kompakt vorliegendes, erfindungsgemäßes Time-of-Flight-Sensormodul 19 zu entnehmen, welches als solches mittels Steckelement 8 an eine externe Elektronik angeschlossen werden kann und ohne weitere Einrichtungserfordernisse in Betrieb genommen werden kann.

## Patentansprüche

1. Time-of-Flight-Sensormodul (19), abgekürzt:_TOF-Sensormodul, das zumindest aufweist:
- eine Platinenanordnung (2) mit einem Optikbereich (2a) und einem Elektronikbereich (2b), wobei der Optikbereich (2a) und der Elektronikbereich (2b) mittels einer Schwenkverbindung (29) mechanisch miteinander verbunden sind,
- einen Moduleinsatz (7) mit einem Trägerabschnitt (7b) zum Halten der Platinenanordnung (2), wobei die Platinenanordnung (2) derart mittels der Schwenkverbindung (29) verklappt ist, dass der Optikbereich (2a) an einer ersten Seite (20) des Trägerabschnitts (7b) mit dem Trägerabschnitt (7b) verbunden ist und der Elektronikbereich (2b) an einer zweiten Seite (21) des Trägerabschnitts (7b) mit dem Trägerabschnitt (7b) verbunden ist, so dass der Trägerabschnitt (7b) zumindest mit einem Abschnitt des Trägerabschnitts (7b) zwischen dem Optikbereich (2a) und dem Elektronikbereich (2b) angeordnet ist,
- eine auf dem Optikbereich (2a) angeordnete Lichtquelle (10) und ein auf dem Optikbereich (2a) angeordneter Lichtsensor (4), die von dem Trägerabschnitt (7b) wegweisend orientiert positioniert sind,
- eine vor der Lichtquelle (10) angeordnete Lichtoptikfassung (11a), in der eine Lichtoptik (3) gehalten wird, und eine vor dem Lichtsensor (4) angeordnete Sensoroptikfassung (11b), in der eine Sensoroptik (5) gehalten wird, wobei wenigstens eine der Lichtoptikfassung (11a) und der Sensoroptikfassung (11b) in einem mit dem Optikbereich (2a) verbundenen Optikgestell (11) angeordnet sind,
- ein Gehäuse (12), in dem der Moduleinsatz (7) eingeführt ist.

2. TOF-Sensormodul (19) nach Anspruch 1, **dadurch gekennzeichnet, dass** der Optikbereich (2a) und der Elektronikbereich (2b) als starre Platinenabschnitte ausgebildet sind, wobei die Schwenkverbindung (29) mechanisch flexibel biegbare Schwenkverbindungselemente (29a, 29b) umfasst.

3. TOF-Sensormodul (19) nach Anspruch 1 oder nach Anspruch 2, **dadurch gekennzeichnet, dass** die Schwenkverbindung (29) ein elektrisches Leitelement umfasst, mittels welchem der Optikbereich (2a) mit dem Elektronikbereich (2b) elektrisch gekoppelt ist.

4. TOF-Sensormodul (19) nach einem der vorhergehenden Ansprüche, **dadurch gekennzeichnet,**
- **dass** der Optikbereich (2a) der Platinenanordnung (2) eine Anzahl von Stecklöchern (24a, 24b, 24c, 24d) aufweist, in die korrespondierende Steckstifte (22a, 22b, 22c, 22d) eingeführt sind, die an der ersten Seite (20) des Trägerabschnitts (7b) angeordnet sind und/oder
- **dass** der Elektronikbereich (2b) der Platinenanordnung (2) eine Anzahl von Stecklöchern (24e, 24f, 24g, 24h) aufweist, in die korrespondierende Steckstifte (22e, 22f, 22g, 22h) eingeführt sind, die an der zweiten Seite (21) des Trägerabschnitts (7b) angeordnet sind und/oder
- **dass** der Optikbereich (2a) der Platinenanordnung (2) eine Anzahl von Aufnahmelöchern (26a, 26b, 26c, 26d, 26e, 26f) aufweist, in die korrespondierende Haltestifte (25a, 25b, 25c, 25d, 25e, 25f) des Optikgestells (11) angeordnet sind zur Anordnung des Optikgestells (11) an dem Optikbereich (2a).

5. TOF-Sensormodul (19) nach Anspruch 4, **dadurch gekennzeichnet,**
- **dass** an der ersten Seite (20) des Trägerabschnitts (7b) wenigstens drei Steckstifte (22a, 22b, 22c, 22d) der ersten Seite (20) angeordnet sind, wobei wenigstens ein erster Steckstift (22a) und ein zweiter Steckstift (22b) der an der ersten Seite (20) angeordneten Steckstifte (22a, 22b, 22c, 22d) als jeweils mindestens eine Quetschrippe aufweisende Positionierstifte (22a, 22b) ausgebildet sind, die derart mit einem korrespondierenden ersten Steckloch (24a) und zweiten Steckloch (24b) des Optikbereichs aufeinander abgestimmt dimensioniert und positioniert sind, dass die Quetschrippe des ersten Steckstifts (22a) der ersten Seite (20) und die Quetschrippe des zweiten Steckstifts (22b) der ersten Seite (20) eine kraftschlüssige Verbindung zwischen Trägerabschnitt (7b) und Optikbereich (2a) herbeiführen, und wobei wenigstens ein dritter Steckstift (22c) der ersten Seite (20) derart mit einem korrespondierenden dritten Steckloch (24c) des Optikbereichs (2a) aufeinander abgestimmt dimensioniert und positioniert ist, dass ein Übermaß des dritten Stecklochs (24c) des Optikbereichs (2a) gegenüber dem dritten Steckstift (22c) der ersten Seite (20) eine Positionierungstoleranz bereitstellen und/oder
**dass** an der zweiten Seite (21) des Trägerabschnitts (7b) wenigstens drei Steckstifte (22e, 22f, 22g, 22h) der zweiten Seite (21) angeordnet sind, wobei wenigstens ein erster Steckstift (22e) und ein zweiter Steckstift (22f) der an der zweiten Seite (21) angeordneten Steckstifte als jeweils mindestens eine Quetschrippe aufweisende Positionierstifte (22e, 22f) ausgebildet sind, die derart mit einem korrespondierenden ersten Steckloch (24e) und zweiten Steckloch (24f) des Elektronikbereichs (2b) aufeinander abgestimmt dimensioniert und positioniert sind, dass die Quetschrippe des ersten Steckstifts (22e) und des zweiten Steckstifts (22f) der zweiten Seite eine kraftschlüssige Verbindung zwischen Trägerabschnitt (7b) und Elektronikbereich (2b) herbeiführen, und wobei wenigstens ein dritter Steckstift (22g) der zweiten Seite (21) derart mit einem korrespondierenden dritten Steckloch (24g) des Elektronikbereichs aufeinander abgestimmt dimensioniert und positioniert ist, dass ein Übermaß des dritten Stecklochs (24g) des Elektronikbereichs (2b) gegenüber dem dritten Steckstift (22g) der zweiten Seite (21) eine Positionierungstoleranz bereitstellen, und/oder
**dass** an einer Befestigungsseite des Optikgestells (11) wenigstens drei Haltestifte (25a, 25b, 25c, 25d, 25e, 25f) angeordnet sind, wobei wenigstens ein erster Haltestift (25b) und ein zweiter Haltestift (25e) jeweils zumindest eine Quetschrippe aufweisen, wobei der erste Haltestift (25b) derart mit einem korrespondierenden ersten Aufnahmeloch (26b) und der zweite Haltestift (25e) derart mit einem korrespondierenden zweiten Aufnahmeloch (26e) des Optikbereichs (2a) aufeinander abgestimmt dimensioniert und positioniert sind, dass die Quetschrippe des ersten Haltestifts (25b) und die Quetschrippe des zweiten Haltestifts (25e) eine kraftschlüssige Verbindung zwischen Optikgestell (11) und Optikbereich (2a) herbeiführen, wobei wenigstens ein dritter Haltestift (25a, 25c, 25d, 25f) des Optikgestells (11) derart mit einem korrespondierenden dritten Aufnahmeloch (26a, 26c, 26d, 26f) des Optikbereichs (2a) aufeinander abgestimmt dimensioniert und positioniert ist, dass ein Übermaß des dritten Aufnahmelochs des Optikbereichs gegenüber dem dritten Haltestift des Optikgestells eine Positionierungstoleranz bereitstellen.

6. TOF-Sensormodul (19) nach einem der vorhergehenden Ansprüche, **dadurch gekennzeichnet, dass** das Optikgestell (11) als einstückiges Bauteil ausgebildet ist, bevorzugt als einstückiges Kunststoffbauteil.

7. TOF-Sensormodul (19) nach einem der vorhergehenden Ansprüche, **dadurch gekennzeichnet, dass** der Trägerabschnitt (7b) eine Führungsausformung aufweist, die in eine Komplementärausformung des Gehäuses (2) eingreift.

8. TOF-Sensormodul (19) nach einem der vorhergehenden Ansprüche, **dadurch gekennzeichnet, dass** der Moduleinsatz (7) an einer Endfläche (7a) ein Steckelement (8) aufweist, durch das eine elektrische Verbindung von einem Gehäuseäußeren zu einem Gehäuseinneren geführt ist.

9. TOF-Sensormodul (19) nach einem der vorhergehenden Ansprüche, **dadurch gekennzeichnet, dass** das Gehäuseäußere und die Platinenanordnung (2) mittels eines Zwischenelements (27) miteinander elektrisch gekoppelt sind, wobei bevorzugt ein Abschnitt des Zwischenelements (27) sich in das Steckelement (8) hinein erstreckt.

10. TOF-Sensormodul (19) nach einem der vorhergehenden Ansprüche, **dadurch gekennzeichnet, dass** auf dem Optikbereich (2a) eine Spot-Diode (6) angeordnet ist zum Markieren eines Erfassungsbereichs des TOF-Sensormoduls (19) auf einer Projektionsfläche.

11. TOF-Sensormodul (19) nach einem der vorhergehenden Ansprüche, **dadurch gekennzeichnet,**
**dass** die Lichtquelle eine Laserdiode oder eine LED ist, und/oder
**dass** der Lichtsensor einen CCD-Chip aufweist.

12. Verfahren zum Zusammenfügen eines Time-of-Flight-Sensormoduls (19), abgekürzt: TOF-Sensormodul, aufweisend die nachfolgenden Schritte:
- Anordnen eines Optikgestells (11) auf einem Optikbereich (2a) einer Platinenanordnung (2a), auf der eine Lichtquelle (10) und ein Lichtsensor (4) angeordnet sind, zum Bereitstellen von einer Lichtoptikfassung (11a) mit einem nachfolgenden Anordnen einer Lichtoptik (3) in der Lichtoptikfassung (11a) und/oder zum Bereitstellen von einer Sensoroptikfassung (11b) mit einem nachfolgenden Anordnen einer Sensoroptik (5) in der Sensoroptikfassung (11b),
- Verbinden des Optikbereichs (2a) der Platinenanordnung (2) mit einer ersten Seite (20) eines Trägerabschnitts (7b) eines Moduleinsatzes (7), indem Steckstifte (22a, 22b, 22c, 22d) der ersten Seite in korrespondierend angeordnete Stecklöcher (24a, 24b, 24c, 24d) des Optikbereichs (2a) geführt werden,
- Verbinden eines Elektronikbereichs (2b) der Platinenanordnung (2) mit einer zweiten Seite (21) des Trägerabschnitts (7b) des Moduleinsatzes (7) auf der Rückseite des Trägerabschnitts (7b), indem Steckstifte (22e, 22f, 22g, 22h) der zweiten Seite in korrespondierend angeordnete Stecklöcher (24e, 24f, 24g, 24h) des Elektronikbereichs (2b) geführt werden, wobei der Elektronikbereich (2b) mittels einer zwischen dem Optikbereich (2a) und dem Elektronikbereich (2b) angeordneten Schwenkverbindung (29) geklappt wird,
- Einsetzen des Moduleinsatzes (7) in ein zur Aufnahme des Moduleinsatzes (7) eingerichtetes Gehäuse (12).

13. Verfahren zum Zusammenfügen eines TOF-Sensormoduls (19) nach Anspruch 12, **dadurch gekennzeichnet, dass** das Anordnen des Optikgestells (11) auf dem Optikbereich (2a) umfasst, dass eine Anzahl von an einer Unterseite des Optikgestells (11) angeordneten Haltestiften (25a, 25b, 25c, 25d, 25e, 25f) in korrespondierend dimensionierte und positionierte Aufnahmelöcher (26a, 26b, 26c, 26d, 26e, 26f) des Optikbereichs (2a) eingeführt werden, wobei wenigstens ein erster Haltestift (25b, 25e) und ein zweiter Haltestift (25b, 25e) mit jeweils zumindest einer Quetschrippe versehen ist, die beim Einführen in die korrespondierenden Aufnahmelöcher (26b, 26e) zu einer kraftschlüssige Befestigung des Optikgestells (11) an dem Optikbereich (2a) beitragen, wobei wenigstens ein weiterer Haltestift (25a, 25c, 25d, 25f) und ein weiteres korrespondierendes Aufnahmeloch (26a, 26c, 26d, 26f) ineinander geführt werden, die derart aufeinander abgestimmt dimensioniert und positioniert ausgebildet sind, dass das weitere Aufnahmeloch (26a, 26c, 26d, 26f) infolge eines Übermaßes gegenüber dem weiteren Haltestift (25a, 25c, 25d, 25f) eine Positionierungstoleranz bereitstellt.

14. Verfahren zum Zusammenfügen eines TOF-Sensormoduls (19) nach Anspruch 12 oder nach Anspruch 13, **dadurch gekennzeichnet, dass** der Platinenabschnitt derart mit der Schwenkverbindung geklappt wird, dass der Optikbereich (2a) an der ersten Seite des Trägerabschnitts (7b) anliegend und der Elektronikbereich (2b) an der zweiten Seite (21) des Trägerabschnitts anliegend mit dem Trägerabschnitt (7b) verbindbar ist.

15. Verfahren zum Zusammenfügen eines TOF-Sensormoduls (19) nach einem der Ansprüche 12 bis 14, **dadurch gekennzeichnet,**
- **dass** ein an der ersten Seite (20) des Trägerabschnitts (7b) angeordneter erster Steckstift (22a) und ein zweiter Steckstift (22b) der ersten Seite (20) in jeweils ein korrespondierendes erstes Steckloch (24a) und zweites Steckloch (24b) des Optikbereichs (2a) eingeführt werden und zumindest eine Quetschrippe des ersten Steckstifts (22a) und zumindest eine Quetschrippe des zweiten Steckstifts (22b) der ersten Seite (20) eine kraftschlüssige Verbindung zwischen Trägerabschnitt (7b) und Optikbereich (2a) herbeiführen, und wobei wenigstens ein dritter Steckstift (22c) der ersten Seite (20) in ein drittes Steckloch (24c) des Optikbereichs (2a) eingeführt wird, wobei ein Übermaß des dritten Stecklochs (24c) des Optikbereichs (2a) gegenüber dem dritten Steckstift (22c) der ersten Seite (20) eine Positionierungstoleranz bereitstellt und/oder
**dass** ein an der zweiten Seite (21) des Trägerabschnitts (7b) angeordneter erster Steckstift (22e) und ein zweiter Steckstift (22f) der zweiten Seite (21) in korrespondierende erstes Steckloch (24e) und zweites Steckloch (24f) des Elektronikbereichs (2b) eingeführt werden und wenigstens eine Quetschrippe des ersten Steckstifts (22e) und wenigstens eine Quetschrippe des zweiten Steckstifts (22f) der zweiten Seite (21) eine kraftschlüssige Verbindung zwischen Trägerabschnitt (7b) und Elektronikbereich (2b) herbeiführen, und wobei wenigstens ein dritter Steckstift (22g) der ersten Seite in ein drittes Steckloch (24g) des Elektronikbereichs (2b) eingeführt wird, wobei ein Übermaß des dritten Stecklochs (24g) des Elektronikbereichs (2b) gegenüber dem dritten Steckstift (22g) der zweiten Seite (21) eine Positionierungstoleranz bereitstellt.

16. Verfahren zum Zusammenfügen eines TOF-Sensormoduls (19) nach einem der Ansprüche 12 bis 15, **dadurch gekennzeichnet, dass** ein Zwischenelement (27) mit einem ersten Endabschnitt mit dem Optikbereich (2a) und/oder mit dem Elektronikbereich (2b) elektrisch gekoppelt wird und mit einem zweiten Endabschnitt in ein Steckelement (8) des Moduleinsatzes (7) eingeführt wird zur Bereitstellung einer elektrischen Verbindung von einem Gehäuseinneren zu dem Gehäuseäußeren.

17. Verfahren zum Zusammenfügen eines TOF-Sensormoduls (19) nach einem der Ansprüche 12 bis 16, **dadurch gekennzeichnet, dass** der Trägerabschnitt (7b) des Moduleinsatzes (7) mit den an dem Trägerabschnitt (7b) in das Gehäuse (12) eingeführt wird, und dabei eine Führungsausformung (33, 34) des Trägerabschnitts (7b) und eine Komplementärausformung (33', 34') des Gehäuses (12) eine Gleitführung des Moduleinsatzes hin zu der Kopplungsposition des TOF-Sensormoduls (19) bewirken.

18. Verfahren zum Zusammenfügen eines TOF-Sensormoduls (19) nach einem der Ansprüche 12 bis 17, **dadurch gekennzeichnet, dass** auf dem Optikbereich (2a) eine Spot-Diode (6) angeordnet wird zum Markieren eines Erfassungsbereichs des TOF-Sensormoduls (19) auf einer Projektionsfläche.

19. Verfahren zum Zusammenfügen eines TOF-Sensormoduls nach einem der Ansprüche 12 bis 18, **dadurch gekennzeichnet,**
**dass** die Lichtquelle eine Laserdiode oder eine LED ist, und/oder
**dass** der Lichtsensor einen CCD-Chip aufweist.
